# EUROPÄISCHE PATENTANMELDUNG

(11) **EP 1 498 951 A2**
(43) Veröffentlichungstag der Anmeldung: **19.01.2005**
(21) Anmeldenummer: 04015057.5
(22) Anmeldetag: 26.06.2004
(51) Int. Cl.: H01L 27/02

(54) **Halbleiterbauelement mit integriertem Übertemperaturschutz**

(30) Priorität: 17.07.2003 DE 10332513
(71) Anmelder: ROBERT BOSCH GMBH, 70442 Stuttgart (DE)
(72) Erfinder: Uebele, Manfred, 72760 Reutlingen (DE); Meinders, Horst, 72762 Reutlingen (DE); Mohaupt, Jens, 72124 Pliezhausen (DE); Wabro, Markus, 72810 Gomaringen (DE); Michel, Hartmut, 72762 Reutlingen (DE)

(57) **Zusammenfassung**

Die Erfindung betrifft ein Halbleiterbauelement zum Steuern eines durch das Halbleiterbauelement fließenden Laststroms, wobei dem Halbleiterbauelement ein einen Wärmesensor aufweisender Übertemperaturschutz zur Vermeidung einer durch einen übermäßigen Laststrom entstehenden Übertemperatur zugeordnet ist.

Es ist vorgesehen, dass der Übertemperaturschutz (5) einschließlich seines Wärmesensors (7) in das Halbleiterbauelement (1) integriert ist.

## Beschreibung

Die Erfindung betrifft ein Halbleiterbauelement zum Steuern eines durch das Halbleiterbauelement fließenden Laststroms mit einem integrierten Übertemperaturschutz.

### Stand der Technik

Halbleiterbauelemente mit einem ihnen zugeordneten Übertemperaturschutz sind bekannt. Dabei verhindert der Übertemperaturschutz, dass das Halbleiterbauelement durch eine zu hohe Eigentemperatur geschädigt oder zerstört wird. Insbesondere die beim Betrieb des Halbleiterbauelements entstehende Wärme, hauptsächlich durch einen Stromfluss durch das Halbleiterbauelement hervorgerufen, soll in einem zulässigen Bereich kontrolliert gehalten werden. Gemäß dem Stand der Technik wird zur Verhinderung einer Schädigung dem Halbleiterbauelement ein separater Temperatursensor verwendet, der zum Beispiel unter Verwendung einer Wärmeleitpaste in thermischen Kontakt mit dem Gehäuse des Halbleiterbauelements gebracht wird. Kommt es im Fehlerfall dazu, dass die Temperatur des Halbleiterbauelements eine bestimmte Temperatur überschreitet, so wird diese Übertemperatur vom Temperatursensor detektiert, und der Temperatursensor greift über eine Steuerleitung in den Betrieb des Halbleiterbauelements ein. Eine bekannte Möglichkeit ist dabei zum Beispiel die Unterbrechung des Stromflusses und das Auslösen eines kontrollierten Spannungsdurchbruchs des Halbleiterbauelements auf einem niedrigem Spannungsniveau. Funktional betrachtet bedeutet dies, dass das Halbleiterbauelement abgeschaltet wird. Erst wenn der Temperatursensor wieder eine zulässige Temperatur detektiert hat, geht das Halbleiterbauelement wieder in seinen normalen Betriebszustand über.

Ein Halbleiterbauelement mit einem zugeordneten Übertemperaturschutz findet zum Beispiel in einer Zündendstufe einer kraftfahrzeugtechnischen Zündanlage eine Anwendung. (Die Schaltungsanordnung einer Zündendstufe ist zum Beispiel aus der DE 196 24 530 A1 bekannt.) Die Primärseite der Zündendstufe wird mit einem großen Strom beaufschlagt, der bei Unterbrechung des Stromflusses eine hohe Spannung induziert, die auf die Sekundärseite zu einer einen Zündfunken bewirkenden Hochspannung übersetzt wird. Während die Zündanlage für den normalen Betrieb bereits so ausgelegt ist, dass eine Übertemperatur der Zündendstufe vermieden wird, so kann für den Fehlerfall nicht ausgeschlossen werden, dass der Strom die Zündendstufe so stark erhitzt, dass diese thermisch geschädigt wird. Daher wird im Fehlerfall die genannte Unterbrechung des Stromflusses und der Spannungsdurchbruch ausgelöst. Dadurch bricht die Spannung auf der Primärseite derart zusammen, dass die auf der Sekundärseite resultierende Spannung nicht mehr zur Erzeugung eines Zündereignisses ausreicht. Aufgrund des fehlenden Zündereignisses reduziert sich der primärseitige Strom, und das Halbleiterbauelement kann sich wieder abkühlen. Sobald die maximal zulässige Temperatur wieder unterschritten ist, wird der gesteuerte Spannungsdurchbruch des Halbleiterbauelements beendet, und das Halbleiterbauelement stellt wieder die für den Betrieb der Zündanlage erforderliche Spannung zur Verfügung.

Nachteilig ist beim Stand der Technik, dass die Bestimmung der tatsächlichen Temperatur des Halbleiterbauelements nur mit einer gewissen Zeitverzögerung und mit einer eingeschränkten Genauigkeit erfolgen kann. Um eine Überhitzung des Halbleiterbauelements dennoch zu verhindern, muss daher die Abschalttemperatur mit einem Sicherheitsabstand zur maximal zulässigen Temperatur gewählt werden, was zu einer ungünstigen Beschränkung des nutzbaren Temperaturbereichs führt. Zudem ist es nachteilig, dass das abrupte Abschalten des Halbleiterbauelements zu einer Funkenbildung führen kann und dass für den Zeitraum der Abschaltung ein das Halbleiterbauelement beinhaltendes elektrisches Modul (zum Beispiel eine Zündendstufe) keine Funktion ausüben kann.

### Vorteile der Erfindung

Das erfindungsgemäße Halbleiterbauelement mit den im Anspruch 1 genannten Merkmalen bietet demgegenüber den Vorteil, dass die Temperaturbestimmung des Halbleiterbauelements mit größerer Genauigkeit und geringerer zeitlicher Verzögerung erfolgt, da der Übertemperaturschutz einschließlich seines Wärmesensors in das Halbleiterbauelement integriert ist und somit eine Erwärmung des Halbleiterbauelements auch eine unmittelbare Erwärmung des Wärmesensors zur Folge hat. Dabei soll der Begriff "integriert" im Rahmen dieser Anmeldung so verstanden werden, dass der Übertemperaturschutz einschließlich seines Wärmesensors auf dem Substrat des Halbleiterbauelements ausgeführt ist. Dadurch wird über das Substrat eine direkte Wärmekopplung des vom Laststrom durchflossenen Bereichs des Halbleiterbauelements und dem Übertemperaturschutz erreicht. Des Weiteren erlaubt die integrierte Bauweise eine platzsparende und kostengünstigere Realisierung des Halbleiterbauelements einschließlich des Übertemperaturschutzes.

Bei einer vorteilhaften Ausgestaltung weist der Wärmesensor eine wärmesensierende Diode auf. Da sich eine Diode in einem Halbleiterbauelement auf einfache Weise realisieren lässt und eine von der Temperatur der Diode abhängige Stromcharakteristik hat, ist somit eine einfache und kostengünstige Ausführungsform des Wärmesensors aufgezeigt. Dabei wird die Diode bevorzugt in Sperrrichtung betrieben, da sie hier über einen größeren Spannungsbereich hochohmig ist, als in Durchlassrichtung, und sich so die wärmesensierende Funktion über einen größeren Spannungsbereich nutzen lässt.

Vorteilhaft ist es, wenn die Diode als Zenerdiode ausgeführt wird. Die Zenerdiode weist im Vergleich zu einer herkömmlichen Diode einen erweiterten Spannungsbereich in Sperrrichtung auf, in dem sie hochohmig ist, und ermöglicht eine Nutzung der wärmesensierenden Funktion in einem vergrößerten Spannungsbereich. Selbstverständlich ist auch der Sperrstrom einer Zenerdiode abhängig von der Temperatur, so dass anhand des die Zenerdiode durchfließenden Stroms ein Rückschluss auf die Temperatur der Diode möglich ist. So sind zum Beispiel Zenerdioden bekannt, deren Sperrstrom sich je Temperaturanstieg um 10 K, um ungefähr einen Faktor 2 erhöht.

Mit Vorteil ist der Diode eine Stromverstärkeranordnung mit mindestens einem Transistor zur Verstärkung des die Diode durchfließenden Diodenstroms zugeordnet. Da der Sperrstrom einer Diode oftmals zu gering ist, um direkt für weitere Steuerungsaufgaben verwendet werden zu können, wird der Diodenstrom mit mindestens einem Transistor verstärkt. Dafür wird die Diode an die Basis eines Transistors angeschlossen, an dessen Kollektor-Emitter-Strecke eine Versorgungsspannung anliegt. Der Sperrstrom der Diode wird dann im Verhältnis der Stromverstärkung des Transistors auf die Kollektor-Emitter-Strecke übersetzt.

Es ist zudem vorteilhaft, wenn die Stromverstärkeranordnung mindestens zwei Transistoren aufweist, die nach dem Darlingtonprinzip kaskadiert angeordnet sind. Gemäß dem Darlingtonprinzip werden Transistoren derart kaskadiert, dass die Basis eines Transistors mit dem Emitter eines anderen Transistors verbunden ist. Damit lässt sich idealerweise eine Multiplizierung der Stromverstärkungen der einzelnen Transistoren erreichen, so dass der Sperrstrom der Diode auf einfache Weise über mehrere Zehnerpotenzen hinweg verstärkt werden kann.

In bevorzugter Ausgestaltung der Erfindung weist das Halbleiterbauelement einen Leistungsbereich mit einer Transistoranordnung zur Steuerung des das Halbleiterbauelement durchfließenden Laststroms auf. Damit lässt sich eine einfache Laststromsteuerung realisieren, da sich eine Transistoranordnung im Herstellungsprozess des Halbleiterbauelements ausbilden lässt und da eine Transistoranordnung die stetige Regelung eines Laststroms ermöglicht.

Es ist vorteilhaft, wenn die Transistoranordnung mindestens zwei Transistoren aufweist, die nach dem Darlingtonprinzip kaskadiert angeordnet sind. Durch eine solche Anordnung ist es möglich, mit einem kleinen Steuerstrom, der in die Basis des ersten Transistors fließt, einen großen Laststrom zu steuern, der entlang der Kollektor-Emitter-Strecke des letzten Transistors in der Transistoranordnung fließt.

Eine weitere vorteilhafte Ausgestaltung liegt vor, wenn der Übertemperaturschutz Teil einer der Steuerung des das Halbleiterbauelement durchfließenden Laststroms dienenden Ansteuerschaltung des Leistungsbereichs ist. Da die Ansteuerschaltung den den Leistungsbereich durchfließenden Laststrom steuert, ist mittels des so angeordneten Übertemperaturschutzes ein direkter Eingriff in die Ansteuerung des Leistungsbereichs gegeben.

Des Weiteren ist es vorteilhaft, wenn die Ansteuerschaltung eine den Laststrom beim Überschreiten einer definierten Temperatur des Halbleiterbauelements reduzierende Ansteuerschaltung oder Regelschaltung ist. Dadurch, dass der Laststrom im Fall einer Übertemperatur lediglich reduziert -und nicht abrupt abgeschaltet- wird, kann die Energieänderung am beziehungsweise im Halbleiterbauelement weitestgehend stetig erfolgen und daher eine Funkenbildung vermieden werden.

Vorteilhafterweise ist die Ansteuerschaltung eine den Laststrom mit steigender Temperatur umso stärker reduzierende Ansteuerschaltung oder Regelschaltung. Es wird damit ermöglicht, auf eine Temperaturerhöhung des Halbleiterbauelements flexibel zu reagieren. Das heißt, wird die maximal zulässige Temperatur nur geringfügig überschritten, so ist eine geringfügige Reduzierung des Laststroms ausreichend, um die Temperatur des Halbleiterbauelements auf einen zulässigen Wert abzusenken; liegt eine größere Temperaturüberhöhung vor, so kann mit einer größeren Reduzierung des Laststroms auf eine Abkühlung des Halbleiterbauelements hingewirkt werden.

### Zeichnung

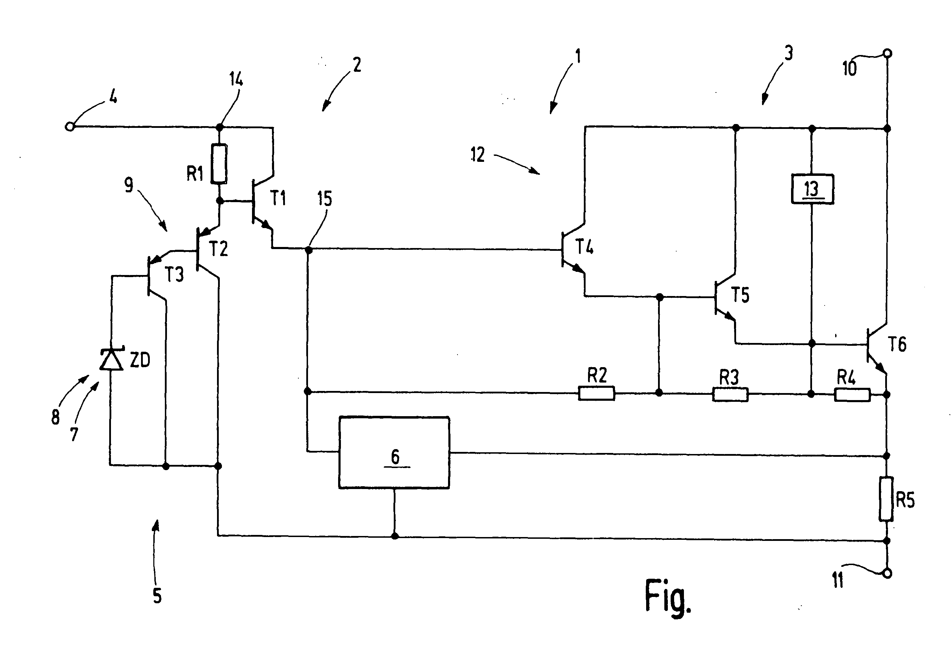

Die Erfindung wird nachfolgend in einem Ausführungsbeispiel anhand der Zeichnung näher erläutert. Die Figur zeigt das Schaltbild eines erfindungsgemäßen Halbleiterbauelements mit einem integrierten Übertemperaturschutz.

### Beschreibung des Ausführungsbeispiels

Die Figur zeigt ein Halbleiterbauelement 1, welches eine Ansteuerschaltung 2 und einen Leistungsbereich 3 aufweist. Die Ansteuerschaltung 2 umfasst die Steuereingangsklemme 4, den Steuertransistor T1, den Übertemperaturschutz 5 und den Stromregler 6, der einen Regeltransistor enthält. Der Übertemperaturschutz 5 weist den Wärmesensor 7 auf, der als Diode 8 in der Bauform einer Zenerdiode ZD ausgeführt ist, des Weiteren einen Widerstand R1 und eine Stromverstärkeranordnung 9, die aus zwei nach dem Darlingtonprinzip kaskadiert angeordneten Transistoren T2 und T3 besteht. Damit fließt über den Widerstand R1 und den Transistor T2 ein Strom, der dem die Zenerdiode ZD durchfließenden Strom mit einer durch die Stromverstärkeranordnung 9 bewirkten Verstärkung entspricht. Dieser Strom wird der Ausgangsklemme 11 zugeleitet.

Der Leistungsbereich 3 weist die Eingangsklemme 10, die Ausgangsklemme 11, die Transistoranordnung 12 mit den in einer dreifach Darlingtonschaltung angeordneten Transistoren T4, T5 und T6, die der Transistoranordnung 12 zugeordneten Widerstände R2, R3 und R4, den Ausgangswiderstand R5 sowie die Spannungsbegrenzungsvorrichtung 13 auf. Die Spannungsbegrenzungsvorrichtung 13 bewirkt, dass über die Transistoren T4, T5 und T6 nur Spannungen bis zu einer gewählten Maximalspannung anliegen können.

Damit ergibt sich folgende generelle Funktionsweise: Im normalen Betriebszustand, das heißt wenn das Halbleiterbauelement eine Temperatur unterhalb seiner maximal zulässigen Höchsttemperatur aufweist, fließt ein Steuerstrom von der Steuereingangsklemme 4 über den Transistor T1 zur Basis des Transistors T4. Dort steuert dieser Strom den Transistor T4 auf, so dass sich aufgrund der mittels der Transistoranordnung 12 bewirkten Stromverstärkung ein verstärkter Laststrom von der Eingangsklemme 10 über die Transistoren T4, T5 und T6 und den Widerstand R5 zur Ausgangsklemme 11 einstellt. Dabei führen Änderungen des über die Steuereingangsklemme 4 zugeleiteten Ansteuerstroms zu weitestgehend proportionalen Änderungen des Laststroms. Der Stromregler 6 hat die Funktion, den Laststrom zu begrenzen, indem ab einem festgelegten Wert des Laststroms ein Teil des Ansteuerstroms am Knoten 15 über den Stromregler 6 zur Ausgangsklemme 11 geleitet wird.

Bei der genannten Temperatur ist der Sperrstrom der Zenerdiode ZD so gering, dass der Stromfluss über den Transistor T2 vernachlässigbar ist. Daher fließt in diesem Betriebszustand auch nur ein vernachlässigbarer Anteil des Steuerstroms vom Knoten 14 über den Widerstand R1 und den Transistor T2 zur Ausgangsklemme 11.

Steigt die Temperatur des Halbleiterbauelements 1 an -üblicherweise wird diese Erwärmung durch den Stromfluss entlang der Verbindung von der Eingangsklemme 10 zur Ausgangsklemme 11 hervorgerufen- so wird auch die Zenerdiode ZD erwärmt und der durch die Zenerdiode ZD fließende Sperrstrom steigt an. Dieser Sperrstrom wird von der Stromverstärkeranordnung 9 verstärkt, so dass der Stromfluss über den Widerstand R1 und den Transistor T2 zur Ausgangsklemme 11 zunimmt. Dies bedeutet, dass ein Teil des Ansteuerstroms nicht mehr an den Eingang des Leistungsbereichs 3 -also an die Basis des Transistors T4- geführt, sondern an der Transistoranordnung 12 vorbeigeführt wird. Diese Reduzierung des Ansteuerstroms bewirkt wiederum eine Reduzierung des Stromflusses von der Eingangsklemme 10 zur Ausgangsklemme 11. Dadurch wird die Wärmeentwicklung, die insbesondere im Transistor T6 entsteht, reduziert, wodurch eine Abkühlung des Halbleiterbauelements 1 ermöglicht ist.

Mit der Abkühlung des Halbleiterbauelements 1 tritt gleichermaßen auch eine Abkühlung der Zenerdiode ZD ein, was wiederum eine Reduzierung des die Diode durchfließenden Diodenstroms zur Folge hat. Aufgrund der Anbindung durch die Stromverstärkeranordnung 9 verringert sich nun auch der Stromfluss über den Transistor T2 zur Ausgangsklemme 11. Dadurch wird die Basis des Transistors T4 wieder mit einem größeren Ansteuerstrom aufgesteuert, so dass auch ein größerer Laststrom von der Eingangsklemme 10 zur Ausgangsklemme 11 fließt.

Das hier gezeigte Halbleiterbauelement 1 ermöglicht es, dass der Übertemperaturschutz 5 funktional nicht in Erscheinung tritt, sofern die Temperatur des Halbleiterbauelements 1 unterhalb der maximal zulässigen Höchsttemperatur liegt. Wird diese Temperatur überschritten, so bewirkt der Übertemperaturschutz 5, dass ein Teil des dem Leistungsbereich 3 zugeführten Ansteuerstroms an der Transistoranordnung 12 vorbeigeführt wird. Die Größe des über den Übertemperaturschutz 5 abgeführten Stroms ist dabei abhängig von der Höhe der Überschreitung der Höchsttemperatur. Somit kann einer Temperaturüberhöhung in den meisten Fällen mit einer Reduzierung des Laststroms begegnet werden, ohne das Halbleiterbauelement abschalten und damit die Funktion des das Halbleiterbauelement beinhaltenden elektrischen Moduls unterdrücken zu müssen.

Ein erfindungsgemäßes Halbleiterbauelement eignet sich auch für den Einsatz in einer Zündspule, da es eine gute elektrische Lastverträglichkeit aufweist und auf plötzliche Temperaturüberhöhungen schnell reagieren kann.

## Patentansprüche

1. Halbleiterbauelement zum Steuern eines durch das Halbleiterbauelement fließenden Laststroms, wobei dem Halbleiterbauelement ein einen Wärmesensor aufweisender Übertemperaturschutz zur Vermeidung einer durch einen übermäßigen Laststrom entstehenden Übertemperatur zugeordnet ist, **dadurch gekennzeichnet, dass** der Übertemperaturschutz (5) einschließlich seines Wärmesensors (7) in das Halbleiterbauelement (1) integriert ist.

2. Halbleiterbauelement nach Anspruch 1, **dadurch gekennzeichnet, dass** der Wärmesensor (7) eine wärmesensierende Diode (8) aufweist.

3. Halbleiterbauelement nach Anspruch 2, **dadurch gekennzeichnet, dass** die Diode (8) als Zenerdiode (ZD) ausgeführt ist.

4. Halbleiterbauelement nach Anspruch 2 oder 3, **dadurch gekennzeichnet, dass** der Diode (8) eine Stromverstärkeranordnung (9) mit mindestens einem Transistor zur Verstärkung des die Diode (8) durchfließenden Diodenstroms zugeordnet ist.

5. Halbleiterbauelement nach Anspruch 4, **dadurch gekennzeichnet, dass** die Stromverstärkeranordnung (9) mindestens zwei Transistoren aufweist, die nach dem Darlingtonprinzip kaskadiert angeordnet sind.

6. Halbleiterbauelement nach einem der vorhergehenden Ansprüche, **dadurch gekennzeichnet, dass** das Halbleiterbauelement (1) einen Leistungsbereich (3) mit einer Transistoranordnung (12) zur Steuerung des das Halbleiterbauelement (1) durchfließenden Laststroms aufweist.

7. Halbleiterbauelement nach Anspruch 6, **dadurch gekennzeichnet, dass** die Transistoranordnung (12) mindestens zwei Transistoren aufweist, die nach dem Darlingtonprinzip kaskadiert angeordnet sind.

8. Halbleiterbauelement nach einem der vorhergehenden Ansprüche, **dadurch gekennzeichnet, dass** der Übertemperaturschutz (5) Teil einer der Steuerung des das Halbleiterbauelement (1) durchfließenden Laststroms dienenden Ansteuerschaltung (2) des Leistungsbereichs (3) ist.

9. Halbleiterbauelement nach einem der vorhergehenden Ansprüche, **dadurch gekennzeichnet, dass** die Ansteuerschaltung (2) eine den Laststrom beim Überschreiten einer definierten Temperatur des Halbleiterbauelements (1) reduzierende Ansteuerschaltung oder Regelschaltung ist.

10. Halbleiterbauelement nach einem der vorhergehenden Ansprüche, **dadurch gekennzeichnet, dass** die Ansteuerschaltung (2) eine den Laststrom mit steigender Temperatur umso stärker reduzierende Ansteuerschaltung oder Regelschaltung ist.
